Europäisches Patentamt

European Patent Office

Office européen des brevets

(11) Numéro de publication: **0 284 153 B1**

# FASCICULE DE BREVET EUROPEEN

(45) Date de publication de fascicule du brevet: **02.06.93**  (51) Int. Cl.5: **H01L 27/02**, H01L 29/10, H01L 29/73

(21) Numéro de dépôt: **88200514.3**

(22) Date de dépôt: **21.03.88**

(54) **Circuit intégré comportant un transistor I2L à courant de sortie élevé et un étage I2L comprenant de tels transistors.**

(30) Priorité: **24.03.87 FR 8704069**

(43) Date de publication de la demande:
**28.09.88 Bulletin 88/39**

(45) Mention de la délivrance du brevet:
**02.06.93 Bulletin 93/22**

(84) Etats contractants désignés:
**DE FR GB IT NL**

(56) Documents cités:

**IEEE JOURNAL OF SOLID STATE CIRCUITS, vol. SC-15, no. 4, août 1980, pages 444-449, IEEE, New York, US; D.D. TANG et al.: "Subnanosecond self-aligned I2I/MTL circuits"**

**IEEE JOURNAL OF SOLID STATE CIRCUITS, vol. SC-11, no. 5, octobre 1976, pages 712-717, New York, US; D.V. KERNS, Jr.: "The effect of base contact position on the relative propagation delays of the multiple outputs of an I2L gate"**

(73) Titulaire: **PHILIPS COMPOSANTS**
**117, quai du Président Roosevelt**
**F-92130 Issy les Moulineaux(FR)**
(84) Etats contractants désignés:
**FR**

(73) Titulaire: **N.V. Philips' Gloeilampenfabrieken**
**Groenewoudseweg 1**
**NL-5621 BA Eindhoven(NL)**
(84) Etats contractants désignés:
**DE GB IT NL**

(72) Inventeur: **Chapron, Claude**
**Société Civile S.P.I.D. 209, rue de l'Université**
**F-75007 Paris(FR)**
Inventeur: **Parpaleix, Jean**
**Société Civile S.P.I.D. 209, rue de l'Université**
**F-75007 Paris(FR)**

(74) Mandataire: **Jacquard, Philippe et al**
**Société Civile S.P.I.D. 156, Boulevard Haussmann**
**F-75008 Paris (FR)**

EP 0 284 153 B1

**Description**

La présente invention a pour objet un circuit intégré comportant un transistor pour logique intégrée à injection (I²L) dont le courant de sortie est nominalement suffisant pour le monter en cascade pour former un étage et comprenant une seule région de sortie de collecteur dont le contour occupe la majeure partie de celui de sa base et comportant au moins un contact de base disposé entre la région de sortie de collecteur et un injecteur.

De tels transistors, présentant un courant de sortie relativement élevé, sont couramment utilisés notamment pour être montés en cascade en sortie d'une porte logique I²L, de manière à interfacer celle-ci avec d'autres composants.

Dans de tels transistors, et à fort courant , la chute de tension dans la base est plus importante que dans une porte logique I²L, ce qui fait que le courant de sortie est nettement moins important que ne le laisse espérer le rapport de surface entre la sortie unique de collecteur du transistor et un collecteur de la porte logique.

On connaît des antériorités US 4 512 075 et US 4 322 882 des transistors I²L dans lesquels la résistance de base est diminuée grâce à la présence d'un contact de base s'étendant sur toute la surface de la base. Or la Demanderesse a constaté qu'une telle solution avait pour inconvénient d'augmenter les phénomènes de recombinaison dans la base, et d'entraîner une diminution du gain, particulièrement gênante dans le cas de transistors travaillant à courant élevé, et donc de plus grandes dimensions.

L'invention a pour objet un transistor I²L à courant de sortie élevé, susceptible notamment d'être monté en cascade pour former un étage, et dans lequel la chute de tension dans la base est diminuée, tout en conservant un gain élevé.

Le principe de base de l'invention consiste à ne réaliser, de manière surprenante, que des contacts de base localisés.

Le transistor I²L selon l'invention est dans ce but caractérisé en ce que la base présente au moins deux rangées de contacts interconnectés, une première rangée constituant ledit contact de base disposé entre la région de sortie de collecteur et l'injecteur, et au moins une deuxième rangée située dans le bord de la région de sortie de collecteur.

Selon un premier mode de réalisation correspondant à une technologie selon laquelle une interconnexion peut être disposée au dessus de la région de sortie de collecteur et séparée de celle-ci par un isolant, la région de sortie de collecteur est en une seule partie et présente au moins une rangée d'inclusions à travers lesquelles la base affleure à la surface, et les contacts de la deuxième rangée de contacts sont disposés sur ladite rangée d'inclusions.

Selon un deuxième mode de réalisation, la région de sortie de collecteur est divisée en au moins deux parties interconnectées, et avantageusement en deux parties, et au moins une dite deuxième rangée de contacts de base est disposée entre lesdites parties.

Selon une variante préférée de ce mode de réalisation, la région de sortie de collecteur est en deux parties et la surface de la partie la plus proche de l'injecteur est le double de celle de l'autre partie.

Selon un mode de réalisation préféré, l'injecteur présente une rangée de contacts d'injecteur.

L'invention sera mieux comprise à la lecture de la description qui va suivre, donnée à titre d'exemple non limitatif, en liaison avec les dessins ci-annexés dans lesquels :
- la figure 1 représente un étage I²L de l'art antérieur comportant une porte I²L et deux transistors I²L montés en cascade pour interfacer la porte I²L
- la figure 2 représente un transistor I²L d'un circuit intégré selon le premier mode de réalisation de l'invention
- les figures 3a, 3b et 4 représentent des transistors d'un circuit intégré selon le deuxième mode de réalisation de l'invention, dans lequel le collecteur est en deux parties interconnectées
- la figure 5 représente les lignes de courant dans la base au voisinage de deux contacts de base et entre ceux-ci
- et la figure 6 représente un détail d'un injecteur d'un transistor selon l'invention.

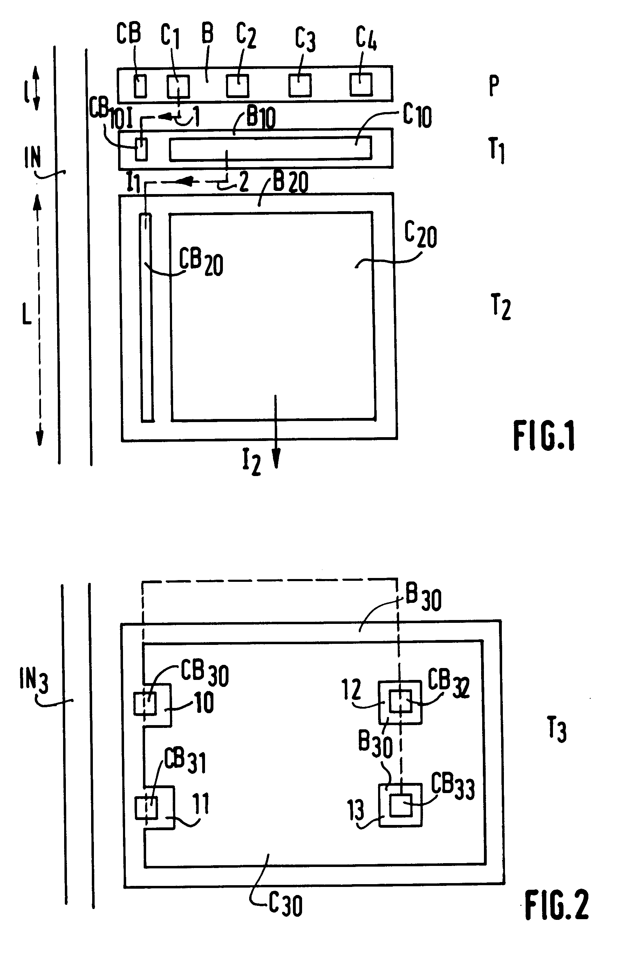

Selon la figure 1, un étage I²L d'un circuit intégré selon l'art antérieur comporte deux transistors I²L $T_1$ et $T_2$ montés en cascade en sortie d'un des collecteurs $C_1$ d'une porte I²L P de manière à interfacer celle-ci avec un ou plusieurs autres composants. Une porte ou un transistor I²L comportent un transistor d'injection, en général PNP, et un transistor de commande du type opposé. La porte I²L P comporte par exemple quatre collecteurs $C_1$....$C_4$ sur lesquels sont réalisés des contacts de collecteur non représentés, une base B et un injecteur I de grande longueur qui est commun avec les transistors I²L $T_1$ et $T_2$, et un contact de base CB entre le collecteur $C_1$ et l'injecteur I. Le transistor $T_1$ présente une base $B_{10}$ de contour extérieur similaire à la base de la porte P. Un collecteur $C_{10}$ de forme rectangulaire allongée occupant une

2

grande partie de la longueur de la base, et un contact de base $CB_{10}$ disposé entre le collecteur $C_{10}$ et l'injecteur. Le collecteur $C_1$ et la base $B_{10}$ sont connectés par une liaison 1 figurée en pointillés et s'étendant depuis le contact du collecteur $C_1$ jusqu'au contact de base $CB_{10}$. Le transistor $T_2$ présente une base $B_{20}$ de contour extérieur sensiblement carré dont un côté borde la base $B_{10}$ et dont un autre côté borde l'injecteur IN. Le collecteur $C_{20}$ du transistor $T_2$ peut avoir une forme sensiblement carrée et son contour occupe la majeure partie de celui de la base $B_{20}$. Un contact de base $CB_{20}$ de forme rectangulaire allongée borde un côté du collecteur $C_{20}$ et est disposé entre celui-ci et l'injecteur IN.

Soit I le courant de sortie de chacun des collecteurs de surface S de la porte P.

Le transistor $T_1$ dont le collecteur $C_{10}$ a une surface $S_1$, délivre un courant de sortie $I_1$, présentant, dans le cas où on le considérerait comme un transistor idéal ayant une résistance de base nulle et ne possédant pas de recombinaison dans la partie de base non recouverte par le collecteur une valeur :

$$I_1 = \frac{S_1}{S} \, I$$

De la même façon, le transistor $T_2$ dont le collecteur $C_{20}$ a une surface $S_2$ présenterait un courant de sortie $I_2$ de valeur :

$$I_2 = \frac{S_2}{S_1} \, I_1 = \frac{S_2}{S} \, I$$

La longueur L de la portion d'injecteur IN qui borde le transistor $T_2$ doit d'autre part être telle que le courant de base de $T_1$ puisse être absorbé par la porte P soit :

$$\frac{L}{l} = \frac{I_1}{I} = \frac{S_1}{S}$$

l désignant la portion d'injecteur IN qui borde la porte P.

En pratique, la résistance de base dans les transistors $T_1$ et $T_2$ est plus importante que dans la porte P et il en résulte que le courant de sortie $I_2$ est notablement inférieur à la valeur donnée ci-dessus.

Selon un premier mode de réalisation de l'invention, représenté à la figure 2, un transistor $T_3$ présente deux rangées de contacts de base. La région de sortie de collecteur consiste en un collecteur $C_{30}$. Une première rangée est constituée par les contacts CB30 et CB31 disposés entre le collecteur $C_{30}$ et l'injecteur IN3 et parallèlement à ce dernier et partiellement inclus dans le collecteur $C_{30}$ dans les inclusions ouvertes 10 et 11 de la base $B_{30}$. Une deuxième rangée est constituée par les contacts CB32 et CB33 disposés dans des inclusions fermées 12 et 13 de la base B30.

La dimension des contacts de base CB30...CB33 est avantageusement la plus faible permise par la technologie. En effet, les recombinaisons sont nettement plus importantes sous la région de prise de contact, ce qui fait qu'en réduisant la dimension des contacts de base, on améliore le gain du transistor $T_3$.

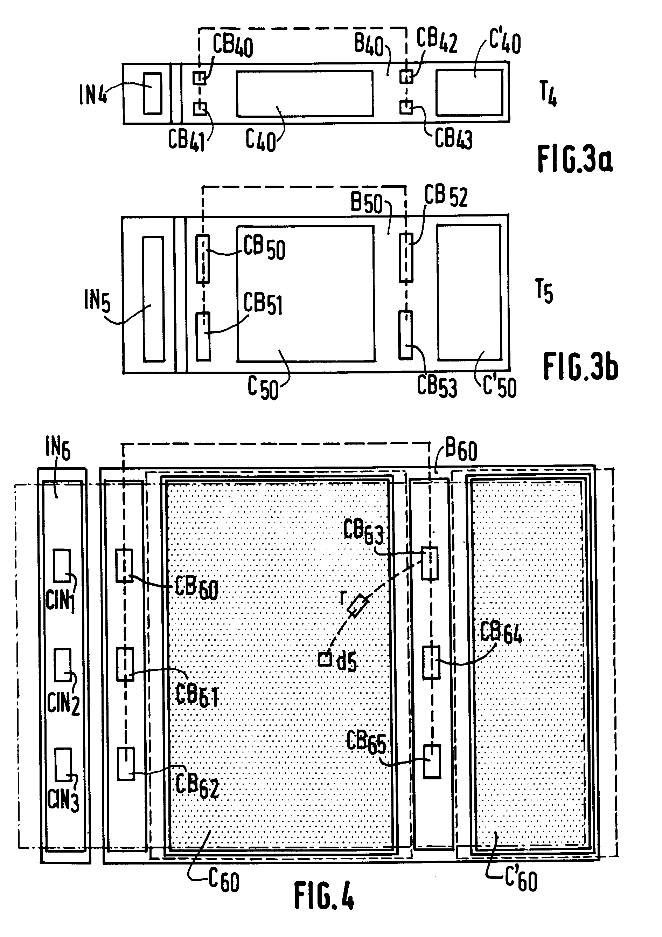

Les figures 3a, 3b et 4 représentent le deuxième mode de réalisation de l'invention dans lequel la région de sortie de collecteur du transistor est divisée en deux parties entre lesquelles est intercalée une rangée de contact de base.

Selon la figure 3a, un transistor $T_4$ correspondant à la configuration du transistor $T_1$ de la figure 1, comporte un injecteur IN4 et une région de sortie de collecteur en deux parties interconnectées, l'une du côté de l'injecteur référencée $C_{40}$, et l'autre à l'opposé, référencée $C'_{40}$ et s'incrivant toutes deux dans le contour de la base $B_{40}$. Les régions $C_{40}$ et $C'_{40}$ ont un contour rectangulaire allongé et, de préférence, la région $C_{40}$ a une surface double de celle de la région $C'_{40}$.

La figure 3b représente un transistor $T_5$ correspondant à la configuration du transistor $T_2$ de la figure 1. Ses éléments constitutifs, à savoir l'injecteur IN5, la région de sortie de collecteur en deux parties interconnectées $C_{50}$ et $C'_{50}$, la base $B_{50}$, la première rangée de contacts de base $CB_{50}$ et $CB_{51}$, et la

deuxième rangée de contact de base $CB_{52}$ et $CB_{53}$ sont disposés de la même façon que les éléments référencés respectivement IN4, $C_{40}$, $C'_{40}$, $B_{40}$, $CB_{40}$, $CB_{41}$, $CB_{42}$, $CB_{43}$. Par contre il se distingue du transistor $T_4$ par la forme de ses éléments, correspondant à la longueur plus importante de l'injecteur et à la surface plus importante des deux parties de la région de sortie de collecteur ($C_{50}$, $C'_{50}$).

Selon la figure 4, l'injecteur IN6 présente également une rangée de contacts interconnectés CIN1, CIN2 et CIN3. La base B60 présente deux rangées de contacts interconnectés, la première rangée comportant les contacts de base CB60, CB61 et CB62, et la deuxième rangée comportant les contacts de base CB63, CB64 et CB65. La région de sortie de collecteur est divisée en deux parties $C_{60}$ et $C'_{60}$ interconnectées, les contacts de la deuxième rangée étant disposés entre les deux parties $C_{60}$ et $C'_{60}$.

Le remplacement d'un contact d'injecteur continu par plusieurs contacts interconnectés améliore le facteur de mérite, donc permet d'assurer les mêmes performances pour une consommation en courant plus faible.

En liaison avec les figures 4 à 6, nous allons maintenant expliquer comment déterminer le nombre et l'espacement des contacts de base et d'injecteur d'une rangée.

En ce qui concerne les contacts de base, deux conditions sont à remplir.

Une première condition concerne l'état de mise en blocage pendant lequel existe un courant de base transitoire important et pour lequel le comportement est assez complexe.

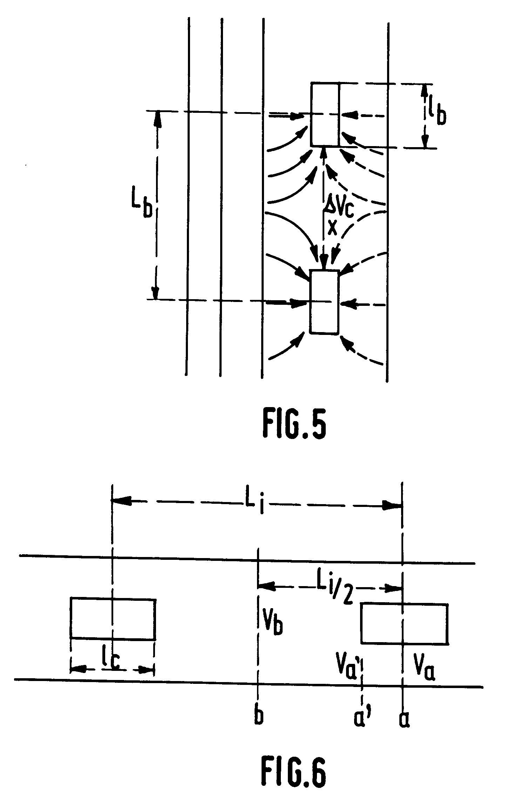

Le courant dont les lignes de courant sont représentées en traits pleins à la figure 5 est très voisin du courant d'injection et est un courant permanent. Le courant représenté en traits pointillés est un courant transitoire dont la valeur peut être supérieure, égale ou inférieure à celle du courant précédent suivant le gain G de la porte de commande. Pour un gain G de 3, il est au maximum égal à deux fois celui-ci pour une structure à deux rangées de contacts de base.

Soit $L_b$ le pas des contacts de base et $l_b$ la longueur des contacts de base.

Pour un écart de tension toléré de $\Delta V_b$ on a approximativement :

$$L_b - l_b = (L_i - l_i)\sqrt{\frac{\Delta V_b}{G}} \quad \Delta V_b \text{ exprimé en mV.}$$

Cette condition est valable pour toutes les rangées de contacts de base.

$\Delta V_b$ doit être choisi inférieur à la chute de tension base-émetteur du transistor en cours de blocage et à une chute de tension collecteur-émetteur du transistor commandé. Soit pour G = 3, $\Delta V_b$ = 100 mV et $L_i - l_i$ = 10$\mu$m (voir plus loin) :

$$L_b - l_b = 60\mu m$$

La deuxième condition est relative à la mise en conduction et le problème est statique. La chute de tension dans la base ne doit pas dépasser 10 mV environ pour un courant de conduction I. Cette deuxième condition est nettement plus restrictive que le première.

L'optimisation de la structure consiste à obtenir le meilleur gain $I^2L$, c'est-à-dire un courant de sortie $I_{OUT}$ maximal.

On a :

$$I_{OUT} = \oiint_S I_0 \, e^{\frac{V(ds)}{kT/q}} \, dS$$

S : surface totale de la base diminuée de la surface des contacts.

V(ds) : tension de polarisation de l'élément de surface dS dans la jonction émetteur-base.

et $V(dS) = V_{CT} - \int r \, I(l) \, dl$

l'intégrale étant prise le long d'une ligne de courant (voir fig.4)

$V_{CT}$ = tension du contact de base.

La diminution de la surface des contacts de base est favorable en ce qu'elle procure une augmentation de $I_{OUT}$ d'une part par diminution de la recombinaison sous les contacts métalliques et d'autre part parce que cette diminution de surface peut être mise à profit pour augmenter la surface du collecteur.

Selon la figure 6, la longueur li d'un contact d'injecteur est choisie de manière que celui-ci ait la surface minimale permise par la technoligie. Le pas Li des contacts d'injecteur doit être choisi de manière telle que le courant d'injection soit sensiblement uniforme le long de l'injecteur.

Soit j la densité linéique de courant le long de l'injecteur. On admet que le gain en courant du transistor d'injection ici PNP, est égal à 1. Le calcul est effectué pour une injection de part et d'autre de l'injecteur.

Soit $\Delta V_i = V_a - V_b$ la différence de tension maximale que l'on admet pour avoir une densité de courant d'injection sensiblement uniforme le long de l'injecteur (b : point situé dans le plan médian entre deux injecteurs, a : point situé dans le plan médian d'un injecteur)

Dans un but de simplification, on suppose également que les lignes de courant sont parallèles à l'injecteur entre les deux contacts, et perpendiculaires à celui-ci au niveau de ces contacts.

Il en résulte Va = Va$'$.

avec a$'$ : point situé dans le plan de l'extrémité d'un contact d'injecteur

D'où :

$$V_{ba} = V_{ba'} = \frac{(Li-li)}{2} \, j \, \frac{2}{W} \, \frac{(L-1)}{2} \, \varrho \, \frac{1}{2} = \varrho \, \frac{(L-1)^2}{4W} j$$

$\dfrac{Li - li}{2} \, j$ : courant injecté entre a' et b

$\dfrac{2}{W} \left( \dfrac{L - 1}{2} \right) \varrho$ : résistance de l'injecteur

$\frac{1}{2}$ : correspond à une densité linéaire dans la résistance de l'injecteur

W : largeur de l'injecteur

j : densité de courant d'injection

$\rho$ : résistance par carré de l'injecteur

$$L_i - l_i = 2\sqrt{\frac{\Delta V W}{\varrho j}}$$

Pour $j = 1 \, \mu A/\mu m = 4\mu m \; W = 5\mu m \; \rho = 500\Omega$ par carré, $\Delta V = 9 10^{-3}$ V (Li - li) = 10 $\mu$m.

## Revendications

**1.** Circuit intégré comportant un transistor pour logique intégrée à injection ($I^2L$) dont le courant de sortie est nominalement suffisant pour la monter en cascade pour former un étage et comprenant une seule région de sortie de collecteur dont le contour occupe la majeure partie de celui de sa base et comportant au moins un contact de base disposé entre la région de sortie de collecteur et un injecteur, caractérisé en ce que la base ($B_{30}$, $B_{40}$, $B_{50}$, $B_{60}$) présente au moins deux rangées de contacts interconnectés, une première rangée ($CB_{30}$, $CB_{31}$, $CB_{40}$, $CB_{41}$, $CB_{50}$, $CB_{51}$, $CB_{60}$, $CB_{61}$, $CB_{62}$) constituant ledit contact de base disposé entre le collecteur et l'injecteur, et au moins une deuxième rangée ($CB_{32}$, $CB_{33}$, $CB_{42}$, $CB_{43}$, $CB_{52}$, $CB_{53}$, $CB_{63}$, $CB_{64}$, $CB_{65}$) située dans le bord de ladite région de sortie de collecteur.

**2.** Circuit intégré selon la revendication 1 caractérisé en ce que la région de sortie de collecteur (C30) est en une seule partie et présente au moins une rangée d'inclusions (12, 13) à travers lesquelles la base affleure à la surface, et en ce que les contacts ($CB_{32}$, $CB_{33}$) de la deuxième rangée de contacts sont disposés sur ladite rangée d'inclusions.

**3.** Circuit intégré selon la revendication 1, caractérisé en ce que la région de sortie de collecteur est divisée en au moins deux parties interconnectées ($C_{40}$, $C'_{40}$, $C_{50}$, $C'_{50}$, $C_{60}$, $C'_{60}$) et en ce qu'au moins une dite deuxième rangée de contacts de base ($CB_{42}$, $CB_{43}$, $CB_{52}$, $CB_{53}$, $CB_{63}$, $CB_{64}$, $CB_{65}$) est disposée entre les parties de collecteur.

**4.** Circuit intégré selon la revendication 3 caractérisé en ce que la région de sortie de collecteur est en deux parties.

**5.** Circuit intégré selon la revendication 4 caractérisé en ce que la surface de la partie la plus proche de l'injecteur est le double de celle de l'autre partie.

**6.** Circuit intégré selon une des revendications précédente caractérisé en ce que l'injecteur présente une rangée de contacts d'injecteur (CIN1, CIN2, CIN3).

**7.** Circuit intégré comportant un étage pour logique intégrée à injection caractérisé en ce qu'il comporte un premier et un deuxième transistors selon l'une des revendications précédentes, la base du second transistor ($T_2$), lequel présente une région de sortie de collecteur de grande dimensions, étant connectée à la région de sortie de collecteur du premier ($T_1$) laquelle est de plus petites dimensions, et en ce qu'il comporte une porte logique $I^2L$ multi-collecteurs (8) dont un des collecteurs ($C_1$) est connecté à la base du premier transistor ($T_1$).

**Claims**

**1.** An integrated circuit comprising a transistor for injection integrated logic ($I^2L$) whose output current is nominally sufficient for mounting it in a cascade arrangement for forming a stage, which comprises a single collector output region whose surface area occupies the major portion of that of the base, and which comprises at least one base contact arranged between the collector output region and an injector, the surface area of the collector output region being several times larger than that of a collector of a multi-collector logic $I^2L$ gate, characterized in that the base ($B_{30}$,$B_{40}$,$B_{50}$,$B_{60}$) has at least two rows of inter-connected contacts, a first row ($CB_{30}$, $CB_{31}$,$CB_{40}$,$CB_{41}$,$CB_{50}$,$CB_{51}$,$CB_{60}$,$CB_{61}$,$CB_{62}$) constituting the said base contact arranged between the collector and the injector, and at least a second row ($CB_{32}$, $CB_{33}$ $CB_{42}$,$CB_{43}$,$CB_{52}$,$CB_{53}$,$CB_{63}$,$CB_{64}$,$CB_{65}$) being situated at the fringe of the collector output region.

**2.** An integrated circuit as claimed in Claim 1, characterized in that the collector output region ($C_{30}$) consists of a single part and has at least one row of inclusions (12,13), through which the base adjoins the surface, and in that the contacts ($CB_{32}$,$CB_{33}$) of the second row of contacts are disposed on the said row of inclusions.

**3.** An integrated circuit as claimed in Claim 1, characterized in that the output collector region is subdivided into at least two interconnected parts ($C_{40}$,$C'_{40}$,$C_{50}$,$C'_{50}$,$C_{60}$,$C'_{60}$), and in that at least one said second row of base contacts ($CB_{42}$,$CB_{43}$,$CB_{52}$,$CB_{53}$,$CB_{63}$,$CB_{64}$,$CB_{65}$) is disposed between the collector parts.

**4.** An integrated circuit as claimed in Claim 3, characterized in that the output collector region consists of two parts.

**5.** An integrated circuit as claimed in Claim 4, characterized in that the surface area of the part closest to the injector is twice that of the other part.

**6.** An integrated circuit as claimed in any one of the preceding Claims, characterized in that the injector has one row of injector contacts ($CIN_1$,$CIN_2$,$CIN_3$).

**7.** An integrated circuit comprising a stage for injection integrated logic, characterized in that it comprises a first and a second transistor as claimed in any one of the preceding Claims, the base of the second transistor ($T_2$), which has a collector output region of large dimensions, being connected to the collector output region of the first transistor ($T_1$), which region has smaller dimensions, and in that it comprises a multi-collector logic $I^2L$ gate (8), of which one of the collectors($C_1$) is connected to the base of the first

transistor ($T_1$).

**Patentansprüche**

1. Integrierte Schaltung mit einem Transistor für integrierte Injektionslogik ($I^2L$), dessen Ausgangsstrom normalerweise ausreicht, um ihn zur Bildung einer Stufe in Kaskade zu schalten, wobei die Schaltung ein einziges Kollektorausgangsgebiet umfaßt, dessen Kontur den größten Teil der Kontur seiner Basis einnimmt, und mindestens einen Basiskontakt enthält, der zwischen dem Kollektorausgangsgebiet und einem Injektor liegt, dadurch gekennzeichnet, daß die Basis ($B_{30}$, $B_{40}$, $B_{50}$, $B_{60}$) mindestens zwei Reihen miteinander verbundener Kontakte hat, wobei eine erste Reihe ($CB_{30}$, $CB_{31}$, $CB_{40}$, $CB_{41}$, $CB_{50}$, $CB_{51}$, $CB_{60}$, $CB_{61}$, $CB_{62}$) den genannten zwischen dem Kollektor und dem Injektor liegenden Basiskontakt bildet, und mindestens eine zweite Reihe ($CB_{32}$, $CB_{33}$, $CB_{42}$, $CB_{43}$, $CB_{52}$, $CB_{53}$, $CB_{63}$, $CB_{64}$, $CB_{65}$) am Rand des Kollektorausgangsgebietes liegt.

2. Integrierte Schaltung nach Anspruch 1, dadurch gekennzeichnet, daß das Kollektorausgangsgebiet (C30) aus einem einzigen Teil besteht und mindestens eine Reihe von Einschlüssen enthält, über die sich die Basis zur Oberfläche erstreckt, und daß die Kontakte ($CB_{32}$, $CB_{33}$) der zweiten Kontaktreihe auf der Reihe aus Einschlüssen angeordnet sind.

3. Integrierte Schaltung nach Anspruch 1, dadurch gekennzeichnet, daß das Kollektorausgangsgebiet in mindestens zwei miteinander verbundene Teile ($C_{40}$, $C'_{40}$, $C_{50}$, $C'_{50}$, $C_{60}$, $C'_{60}$) unterteilt ist und daß mindestens eine genannte zweite Basiskontaktreihe ($CB_{42}$, $CB_{43}$, $CB_{52}$, $CB_{53}$, $CB_{63}$, $CB_{64}$, $CB_{65}$) zwischen den Kollektorteilen liegt.

4. Integrierte Schaltung nach Anspruch 3, dadurch gekennzeichnet, daß das Kollektorausgangsgebiet aus zwei Teilen besteht.

5. Integrierte Schaltung nach Anspruch 4, dadurch gekennzeichnet, daß die dem Injektor am nächsten gelegene Fläche doppelt so groß ist wie die des anderen Teils.

6. Integrierte Schaltung nach einem der vorhergehenden Ansprüche, dadurch gekennzeichnet, daß der Injektor eine Injektorkontaktreihe (CIN1, CIN2, CIN3) aufweist.

7. Integrierte Schaltung mit einer Stufe in integrierter Injektionslogik, dadurch gekennzeichnet, daß sie einen ersten und einen zweiten Transistor nach einem der vorhergehenden Ansprüche enthält, wobei die Basis des zweiten Transistors ($T_2$), der ein Kollektorausgangsgebiet mit großen Abmessungen aufweist, mit dem Kollektorausgangsgebiet des ersten Transistors ($T_1$) verbunden ist, das viel kleinere Abmessungen hat, und daß sie ein Multikollektor-$I^2L$-Logikgatter (8) hat, wobei einer dessen Kollektoren ($C_1$) mit der Basis des ersten Transistors ($T_1$) verbunden ist.

EP 0 284 153 B1

FIG.1

FIG.2

8

FIG.3a

T₄

FIG.3b

T₅

FIG.4

FIG.5

FIG.6